# EUROPEAN PATENT SPECIFICATION

(11) **EP 4 521 890 B1**
(45) Date of publication and mention of the grant of the patent: **21.01.2026**
(21) Application number: 24195245.6
(22) Date of filing: 19.08.2024
(51) Int. Cl.: H10H 29/01, H10H 29/32, H10H 29/45, H10H 29/80

(54) **DISPLAY DEVICE AND REPAIR METHOD**
ANZEIGEVORRICHTUNG UND REPARATURVERFAHREN
DISPOSITIF D'AFFICHAGE ET PROCÉDÉ DE RÉPARATION

(30) Priority: 08.09.2023 JP 2023145916
(43) Date of publication of application: 12.03.2025
(73) Proprietor: Alps Alpine Co., Ltd., Ota-ku, Tokyo 145-8501 (JP)
(72) Inventor: Kishida, Katsuhiko, Iwaki-city Fukushima (JP)
(74) Representative: Schmitt-Nilson Schraud Waibel Wohlfrom Patentanwälte Partnerschaft mbB

(56) References cited:
- US-A1- 2018 151 632
- US-A1- 2019 172 760
- US-A1- 2020 388 736

## Description

The present disclosure relates to a display device in which a plurality of light-emitting elements are formed on a substrate, and in particular, to repair when a defect occurs in a micro light-emitting diode (LED), and to a repair method for repairing a defective light-emitting diode in a display.

In recent years, micro LEDs that can display images directly from light-emitting diodes have been developed. The micro LEDs are two-dimensionally arranged to correspond to pixels. For color images, each of the pixels includes blue, green, and red sub-pixels.

For example, JP 2021-504752A discloses a passive-driven display LED stack including: a red (R) first LED stack, a green (G) second LED stack, and a blue (B) third LED stack that are vertically stacked; anodes of the light-emitting diodes of the first LED stack to the third LED stack that are connected to common data interconnect; and cathodes of the light-emitting diodes that are connected to scan interconnects 1, 2, and 3, the R, G, and B light-emitting diodes in the same pixel being driven independently of each other.

U.S. 11,171,270B discloses an active-driven micro LED including, on a semiconductor layer: a thin-film transistor (TFT) including a gate electrode, a drain electrode, and a source electrode; a planarization layer formed so as to cover the TFT; a first electrode formed on the planarization layer and connected to the source electrode via a via hole in the planarization layer; and an LED formed between the first electrode and a second electrode that is formed above the first electrode.

In a display using a micro LED, when a failure or a defect of mounting of the micro LED occurs, it is necessary to repair the micro LED. For example, JP 2022-140934A discloses a repair method for removing a defective LED chip from a substrate, on which many LED chips are mounted, by transferring the defective LED chip to an adhesive film by heating the detective LED chip with a laser. JP 2023-3062A discloses a chip repair method including: providing a transfer carrier holding a replacement chip; aligning a to-be-repaired part of a to-be-repaired substrate and the replacement chip held on the transfer carrier so as to face each other; and transferring the replacement chip to the to-be-repaired substrate.

US 2019/172760 A1 and US 2020/338736 A1 disclose display repair methods according to the prior art. US 2018/151632 A1 discloses stacking transparent substrates on which LEDs are mounted on top of each other in order to form a multicolour display.

An existing micro LED repair method includes: (1) detecting an abnormal position of a defective micro LED on a substrate by inspection; (2) removing the defective micro LED from the substrate; and (3) remounting a micro LED for repair on the substrate. However, for removal of the micro LED, the micro LED is heated with a laser. This requires avoidance of damaging an interconnect pattern, and requires delicate work and many steps, resulting in great increase in cost.

The present disclosure provides a display device and a repair method capable of readily and cost-effectively repairing a defective LED.

The present disclosure relates to a display device and a repair method according to the appended claims. Embodiments are disclosed in the dependent claims. The display device according to an aspect of the present disclosure includes: a first substrate including a plurality of light-emitting elements arranged two-dimensionally; and a second substrate stacked on the first substrate. At least the second substrate is transparent. The second substrate includes a repair light-emitting element arranged on the second substrate at a position thereon that corresponds to a defective light-emitting element on the first substrate.

In one embodiment, the first substrate and the second substrate have the same configuration. In a further embodiment, the first interconnect formed on the surface of the first substrate has the same configuration as the second interconnect formed on the surface of the second substrate. In one embodiment, the display device further includes a drive circuit connected to the first interconnect and the second interconnect, and the drive circuit is configured to simultaneously drive a light-emitting element on the first substrate and a light-emitting element on the second substrate. In one embodiment, a plurality of light-emitting elements are formed on the second substrate at positions thereon that do not overlap with positions of the plurality of light-emitting elements on the first substrate. In one embodiment, each of the first interconnect and the second interconnect includes a plurality of data lines and a plurality of scan lines, the first substrate includes a light-emitting element at intersections between the plurality of data lines and the plurality of scan lines, and the second substrate includes a repair light-emitting element at an intersection between a selected data line and a selected scan line. In one embodiment, the light-emitting element is a micro LED.

The repair method according to a further aspect of the present disclosure is a method for repairing a defective LED in a transparent display in which a plurality of micro LEDs are mounted. In the repair method, a second transparent substrate is stacked on a first transparent substrate containing the defective LED, and the repair LED is mounted at a position corresponding to the defective LED on the second transparent substrate.

According to aspects of the present disclosure, since the repair light-emitting element is arranged on the second substrate that is stacked on the first substrate, removing the defective light-emitting element from the first substrate becomes unnecessary. Accordingly, the repair work can be simplified, the efficiency of the repair work can be improved, and increase in cost can be suppressed.
FIG. 1 is a block diagram illustrating a schematic configuration of a display device according to one embodiment of the present disclosure;
FIG. 2 is a schematic cross-sectional view of a transparent display according to one embodiment of the present disclosure;
FIG. 3 is a schematic cross-sectional view of a transparent display of a display device according to a first embodiment of the present disclosure;
FIG. 4A is a schematic plan view of a transparent drive substrate according to the first embodiment;
FIG. 4B is a schematic plan view of a transparent repair substrate according to the first embodiment;
FIG. 5 is a schematic cross-sectional view of a transparent display according to a second embodiment of the present disclosure;
FIG. 6A is a schematic cross-sectional view of a transparent display according to a third embodiment of the present disclosure; and
FIG. 6B is a schematic cross-sectional view of the transparent display according to the third embodiment of the present disclosure.

The present disclosure relates to a display device including a substrate on which a plurality of light-emitting elements are formed. In particular, the present disclosure relates to a display device that, when a defect of the light-emitting element is detected, arranges on a stacked substrate, the light-emitting element for repairing the defective light-emitting element. The light-emitting element is not particularly limited, but is, for example, a micro LED. It should be noted that the drawings referred to in the following description include exaggerated representations to facilitate understanding of the disclosure and are not intended to represent the shape or scale of the actual product.

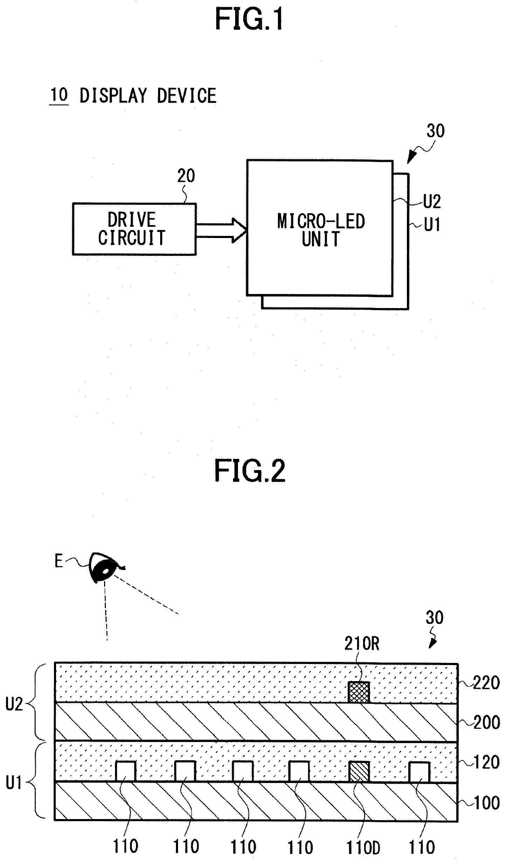

FIG. 1 is a block diagram illustrating the configuration of a display device according to one embodiment of the present disclosure. As illustrated in FIG. 1, a display device 10 includes a drive circuit 20 and a transparent display 30 driven by the drive circuit 20. The transparent display 30 includes a stack of two micro LED units U1 and U2, and the micro LED units U1 and U2 are driven by the drive circuit 20 independently of each other.

FIG. 2 is a schematic cross-sectional view of the transparent display 30. The lower micro LED unit U1 includes a transparent drive substrate 100, a plurality of micro LEDs 110 arranged in a matrix on the transparent drive substrate 100, and a transparent protective agent 120 formed to cover the surface of the transparent drive substrate 100 including the plurality of micro LEDs 110. The upper micro LED unit U2 includes a transparent repair substrate 200, one or a plurality of repair LEDs 210 arranged on the transparent repair substrate 200, and a transparent protective agent 220 formed to cover the surface of the transparent repair substrate 200 including the one or a plurality of repair LEDs 210. The transparent repair substrate 200 is stacked on the transparent drive substrate 100 such that a back surface of the transparent repair substrate 200 contacts the transparent protective agent 120.

When a defective LED 110D is detected among a plurality of micro LEDs 110 mounted on the transparent drive substrate 100, the repair LED 210 is mounted on the transparent repair substrate 200 at a position corresponding to the defective LED 110D, i.e., directly above the defective LED 110D. When the image is displayed by the transparent display 30, the transparent drive substrate 100 and the transparent repair substrate 200 are simultaneously driven, respectively, and the user E sees a composite of an image generated by the transparent drive substrate 100 and an image generated by the transparent repair substrate 200.

Thus, by supplementing the defective LED 110D of the transparent drive substrate 100 with the LED 210 of the stacked transparent repair substrate 200, it is possible to eliminate the work of removing the defective LED 110D from the transparent drive substrate 100 as in the existing manner. It should be noted that the upper micro LED unit U2 must be formed of a transparent substrate, but the lower micro LED unit U1 may not necessarily be a transparent substrate.

A transparent display using micro LEDs has several tens of *µ*m of LED chips, and a full high definition (HD) display has 1920×1080 pixels, and the number of LED chips to be mounted is 1920×1080×3 (RGB), or approximately 6.22 million. Therefore, LED defects often occur, and repair work is essential. Existing repair work requires many man-hours to remove defective LEDs and to transfer the detective LEDs, etc. Also, these processes require delicacy that does not damage the interconnect pattern on the substrate, thus, resulting in an increase in cost. On the other hand, as in the present embodiment, it is more advantageous in terms of process simplification and costs, to stack a transparent repair substrate and mount the LEDs for repair on the transparent repair substrate.

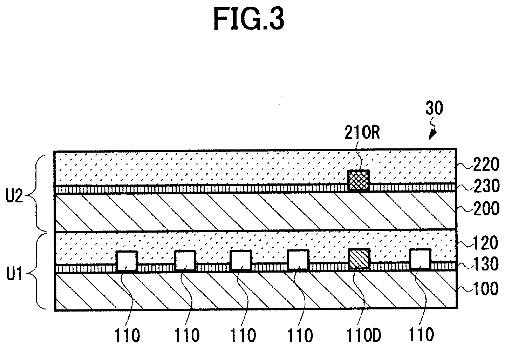

Next, a first embodiment of the present disclosure will be described. FIG. 3 is a schematic cross-sectional view of a transparent display of a display device according to the first embodiment of the present disclosure, and the same reference numerals as those of FIG. 2 are used for the same configuration.

The lower micro LED unit U1 includes a rectangular transparent drive substrate 100. The transparent drive substrate 100 is configured using, for example, a light-transmissive substrate such as glass, plastic, acrylic, or a transparent film.

A substrate interconnect 130 is formed on the surface of the transparent drive substrate 100. The material of the substrate interconnect 130 is not particularly limited, but is, for example, a conductive material such as Cu or a light-transmissive conductive material such as ITO. Using these conductive materials, an interconnect pattern (for example, data electrode interconnect, scan electrode interconnect, etc.) is formed on the transparent drive substrate 100.

The plurality of micro LEDs 110 are mounted in a matrix or arbitrary pattern (for example, 8-segment display) on the surface of the transparent drive substrate 100 so as to be electrically connected to the substrate interconnect 130. For example, at each intersection of the data electrode interconnect and the scan electrode interconnect, one electrode of the micro LED is connected to the data electrode interconnect, and the other electrode is connected to the scan electrode interconnect.

A transparent protective agent 120 is formed on the transparent drive substrate 100 to cover the plurality of micro LEDs 110. The transparent protective agent 120 is formed of materials such as, but not limited to, polyethylene terephthalate (PET), polypropylene (PP), and polyvinyl chloride (PVC).

The upper micro LED unit U2 includes a transparent repair substrate 200 on which a substrate interconnect 230 is formed. In one embodiment, the transparent repair substrate 200 includes the same material, has the same size, and includes the same substrate interconnect as the transparent drive substrate 100. Accordingly, the transparent drive substrate 100 and the transparent repair substrate 200 have a same configuration. In another embodiment, the transparent repair substrate 200 may be made of a different material, have a different size, and include different substrate interconnect from the transparent drive substrate 200. However, the former embodiment is more cost advantageous because the transparent substrates have the same configuration.

A repair LED 210 is mounted on the transparent repair substrate 200 at a position corresponding to a defective LED on the transparent drive substrate 100. The repair LED 210 is mounted on the transparent repair substrate 200 by, for example, thermal pressure bonding a material containing conductive particles on the substrate interconnect 230. A transparent protective agent 220 is formed on the transparent repair substrate 200 to cover one or a plurality of repair LEDs 210.

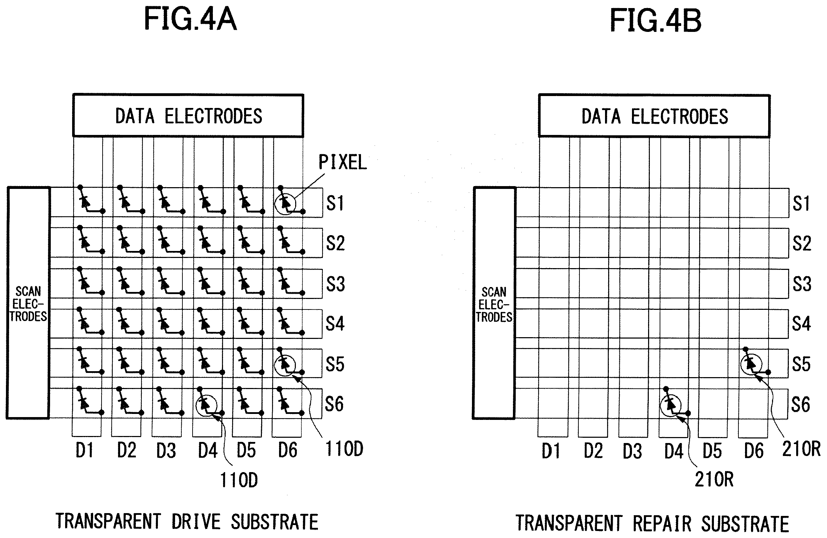

FIG. 4A is a schematic plan view of a transparent drive substrate, and FIG. 4B is a schematic plan view of a transparent repair substrate. As illustrated in FIG. 4A, a plurality of scan electrode interconnects S1, S2, ..., S5, and S6 extending in a row direction (X direction) and a plurality of data electrode interconnects D1, D2, ..., D5, and D6 extending in a column direction (Y direction) are formed on the transparent drive substrate 100 as substrate interconnects 130. A micro LED 110 is connected to each intersection of the plurality of scan electrode interconnects and the plurality of data electrode interconnects. Although the six scan electrode interconnects and the data electrode interconnects of passive driving are illustrated here for convenience, the number of scan electrode interconnects and the data electrode interconnects according to the number of pixels are actually formed. A switching element may be arranged at the intersections of the scan electrode interconnects and the data electrode interconnects to serve as active driving.

Although the scan electrode interconnects and the data electrode interconnects are illustrated linearly, the shape and pattern of the interconnects are appropriately determined according to the position of the anode/cathode of the micro LED. At the intersection of the scan electrode interconnect and the data electrode interconnect, for example, the cathode electrode of the micro LED is electrically connected to the scan electrode interconnect, and the anode electrode of the micro LED is electrically connected to the data electrode interconnect.

In FIG. 4A, one pixel is illustrated as one micro LED. However, when the transparent display 30 displays a color image, one pixel is formed of three sub-pixels that generate red (R), green (G), and blue (B). The composition of the R, G, and B sub-pixels is not particularly limited, but may be formed of, for example, a red-emitting diode, a green-emitting diode, and a blue-emitting diode, or alternatively, a fluorescent filter that generates red and green from the blue-emitting diode may be used to form the R and G light-emitting elements. When the R, G, and B sub-pixels are included, each of the R, G, and B sub-pixels is connected to both the scan electrode interconnect and the data electrode interconnect. The micro LED may be, for example, a white diode generating white light or an infrared diode generating infrared light.

In FIG. 4A, two defective LEDs 110D are illustrated at the intersection of the scan electrode interconnect S5 and the data electrode interconnect D6 and the intersection of the scan electrode interconnect S6 and the data electrode interconnect D4. When the micro LED includes R, G, and B sub-pixels, the defective LED 110D represents a defect in one of the R, G, and B sub-pixels. A defect in the LED includes, for example, a defective connection between the anode/cathode electrodes of the micro LED and the interconnect, or a failure or defect of the LED itself.

In one embodiment, detection of the defective LED causes all of the micro LEDs 110 mounted on the transparent drive substrate 100 to be fully lit, and at this time identifies the location of the micro LEDs not emitting light. For example, an imaging camera may be used to image the fully light-emitting micro LEDs of the transparent drive substrate 100, detect the location of the micro LEDs not emitting light from the captured image, and determine the micro LEDs not emitting light to be the defective LEDs. The defective LED detection processing may be performed using, for example, a computer device, and the positional information of the defective LEDs may be used when mounting the repair LEDs 210 on the transparent repair substrate 200.

The scan electrode interconnect and the data electrode interconnect as illustrated in FIG. 4A are interconnects for passive driving. The drive circuit 20 as illustrated in FIG. 1 drives the scan electrode interconnect by time-division at a constant scan frequency. Also, the drive circuit 20 applies, in synchronization with the scan frequency of the scan electrode interconnect, a data signal (drive current) corresponding to the image data to be displayed to the data electrode interconnects D1, D2, ..., D5, and D6. As a result, the micro LED emits light at a luminance corresponding to the applied data signal.

For example, when the scan electrode interconnect S1 is driven, data signals from the data electrode interconnects D1, D2, ..., D5, and D6 are applied to respective micro LEDs at the intersections of the scan electrode interconnect S1 and the data electrode interconnects D1, D2, ..., D5, and D6, and the micro LEDs of this line emit light. Next, when the scan electrode interconnect S2 is driven, data signals from the data electrode interconnects D1, D2, ..., D5, and D6 are applied to respective micro LEDs at the intersections of the scan electrode interconnect S2, and the micro LEDs of this line emit light. In such a way, the scan electrode interconnects are sequentially driven from S1 to S6 to display one frame. In the example as illustrated in the figure, the defective LED 110D at the intersection of the scan electrode interconnect S5 and the data electrode interconnect D6, and the defective LED 110D at the intersection of the scan electrode interconnect S6 and the data electrode interconnect D4, do not emit light.

As illustrated in FIG. 4B, the transparent repair substrate 200 includes the same substrate interconnect as the transparent drive substrate 100, that is, the same scan electrode interconnect and data electrode interconnect. However, only the repair LED 210 for compensating the defective LED 110D is mounted on the transparent repair substrate 200. For example, when the defective LED is a subpixel R micro LED, the repair LED is an R micro LED. When the transparent repair substrate 200 is aligned with the transparent drive substrate 100, the repair LED 210 is arranged at a position corresponding to the defective LED 110D.

The drive circuit 20 is connected to the micro LED units U1 and U2, respectively, and drives the micro LED units U1 and U2 simultaneously with and independently of each other. That is, the scan electrode interconnect and the data electrode interconnect that are of the transparent drive substrate 100 and the transparent repair substrate 200 are simultaneously driven. For example, when the scan electrode interconnect S5 is scanned, the defective LED 110D of the data electrode interconnect D6 of the transparent drive substrate 100 does not emit light, but the repair LED 210R of the transparent repair substrate 200 emits light in response to the data signal applied from the data electrode interconnect D6. Then, when the scan electrode interconnect S6 is scanned, the defective LED 110D of the data electrode interconnect D4 of the transparent drive substrate 100 does not emit light, but the repair LED 210R of the transparent repair substrate 200 emits light in response to the data signal applied from the data electrode interconnect D4.

According to the present embodiment, by the transparent drive substrate and the transparent repair substrate having the same configuration, it is possible to repair only with the existing transparent drive substrate without generating a new transparent repair substrate, and as a result, the cost of the display device can be reduced.

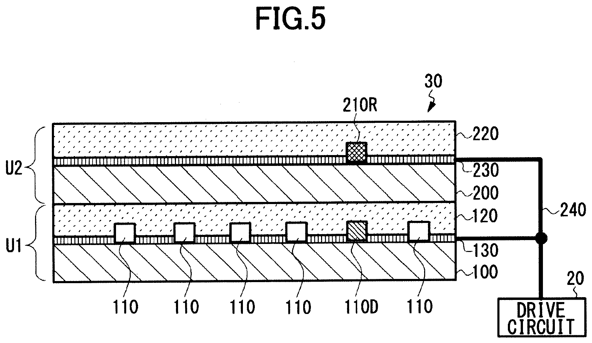

Next, a second embodiment of the present disclosure will be described. FIG. 5 is a schematic cross-sectional view of a transparent display according to the second embodiment. In the second embodiment, the substrate interconnect 130 of the transparent drive substrate 100 and the substrate interconnect 230 of the transparent repair substrate 200 that are used in the first embodiment are connected by the interconnect 240, and the connected interconnect 240 is connected to the drive circuit 20. The drive circuit 20 drives the transparent drive substrate 100 and the transparent repair substrate 200 through the common interconnect 240. As a result, a dedicated drive circuit for the transparent repair substrate 200 is not required, thereby reducing the cost. Since the transparent drive substrate 100 and the transparent repair substrate 200 are interconnect boards of same configuration, they can be easily connected by using an inter-board connector for interconnect connection.

Next, a third embodiment of the present disclosure will be described. In the third embodiment, in order to achieve a high-resolution and high-definition transparent display, a repair LED is mounted on an upper transparent drive substrate using a method of stacking a transparent drive substrate on which a micro LED is mounted.

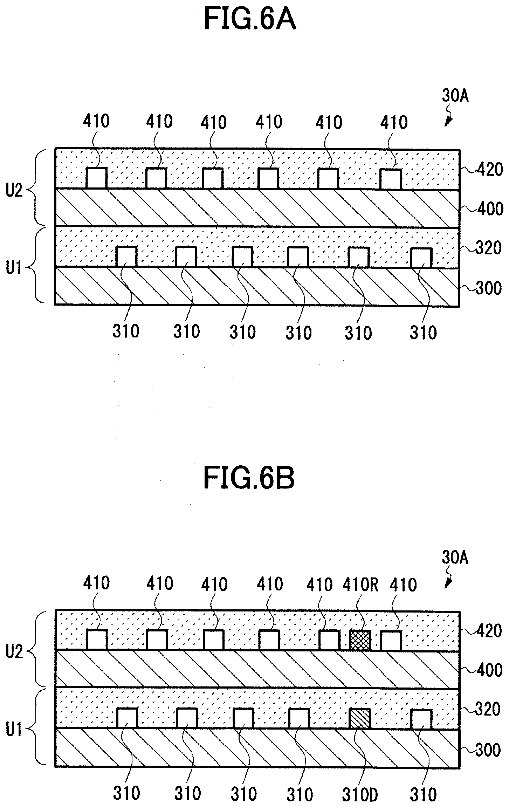

FIG. 6A is a schematic cross-sectional view of the transparent display 30A according to the third embodiment. The transparent display 30A includes a stack of a lower micro LED unit U1 and an upper micro LED unit U2. The lower micro LED unit U1 includes a lower transparent drive substrate 300, a plurality of micro LEDs 310 two-dimensionally mounted on the lower transparent drive substrate 300, and a transparent protective agent 320 covering the surface of the lower transparent drive substrate 300. The upper micro LED unit U2 includes an upper transparent drive substrate 400, a plurality of micro LEDs 410 two-dimensionally mounted on the upper transparent drive substrate 400, and a transparent protective agent 420 covering the surface of the upper transparent drive substrate 400.

The micro LEDs 310 mounted on the lower transparent drive substrate 300 are arranged such that positions thereon do not overlap with those of the micro LEDs 420 mounted on the upper transparent drive substrate 400. For example, the rows and columns of the micro LEDs 310 are shifted by 1/2 from the rows and columns of the micro LEDs 420 so that the micro LEDs 310 and micro LEDs 420 are arranged in a staggered manner.

When an image is displayed on the transparent display 30A, the drive circuit 20 drives the micro LED unit U1 by time division at a scan frequency F1 and drives the micro LED unit U2 by time division at a scan frequency F2 (F2 = F1). Light emitted from the micro LED 310 of the lower transparent drive substrate 300 enters from the back surface of the upper transparent drive substrate 400 and is emitted from the front surface of the transparent protective agent 420. Additionally, light emitted from the micro LED 410 of the upper transparent drive substrate 400 is also emitted through the transparent protective agent 420 from the front surface thereof. Thus, a frame image generated by the micro LED unit U1 and a frame image generated by the micro LED unit U2 are combined to display a high-resolution and high-definition image.

Here, as illustrated in FIG. 6B, when a defective LED 310D is detected on the lower transparent drive substrate 300, a repair LED 410R is mounted to the position corresponding to the defective LED 310D on the upper transparent drive substrate 400.

Thus, according to the present embodiment, when a high-definition transparent display is configured by stacking the transparent drive substrates, the repair LED can be arranged on the upper transparent drive substrate. Accordingly, by not adding a new repair substrate, a more cost-advantageous configuration can be achieved as described in the first and second embodiments.

Although embodiments of the present invention have been described in detail above, the present invention is not limited to these specific embodiments and can be modified in various ways within the scope of the claims.

## Claims

1. A display device (10), comprising:
a first substrate (100) including a plurality of light-emitting elements (110) arranged two-dimensionally; and
a second substrate (200) stacked on the first substrate, wherein
at least the second substrate is transparent, and
the second substrate includes a repair light-emitting element (210R) arranged on the second substrate at a position thereon that corresponds to a defective light-emitting element (110D) on the first substrate, the defective light-emitting element being from among the light-emitting elements.

2. The display device according to claim 1, wherein the first substrate and the second substrate have a same configuration.

3. The display device according to claim 1 or 2, wherein
a first interconnect formed on a surface of the first substrate has a same configuration as a second interconnect formed on a surface of the second substrate.

4. The display device according to claim 3, further comprising:
a drive circuit connected to the first interconnect and the second interconnect, wherein
the drive circuit is configured to simultaneously drive the light-emitting elements on the first substrate and a light-emitting element on the second substrate.

5. The display device according to one of claims 1 to 4, wherein
the second substrate includes a plurality of light-emitting elements formed on the second substrate at positions thereon that do not overlap with positions of the plurality of light-emitting elements on the first substrate.

6. The display device according to one of claims 3 to 5, wherein
the first interconnect and the second interconnect each include a plurality of data lines and a plurality of scan lines,
the first substrate includes the light-emitting elements at intersections between the plurality of data lines and the plurality of scan lines, and
the second substrate includes a repair light-emitting element at an intersection of: a selected data line that is selected from the plurality of data lines; and a selected scan line that is selected from the plurality of scan lines.

7. The display device according to one of claims 1 to 6, wherein the light-emitting elements are each a micro light-emitting diode (LED).

8. A repair method for repairing a defective light-emitting diode (LED) in a display mounted with a plurality of micro LEDs, the repair method comprising:
stacking a second transparent substrate (200) on a first substrate (100) including the defective LED (110D), and
mounting a repair LED (210R) on the second transparent substrate at a position thereon that corresponds to the defective LED.

## Patentansprüche

1. Anzeigevorrichtung (10), aufweisend:
ein erstes Substrat (100), das eine Mehrzahl von zweidimensional angeordneten Lichtemissionselementen (110) aufweist; und
ein zweites Substrat (200), das auf das erste Substrat gestapelt wird, wobei mindestens das zweite Substrat transparent ist, und
das zweite Substrat ein Reparaturlichtemissionselement (210R) aufweist, das auf dem zweiten Substrat an einer Position darauf angeordnet wird, die einem defekten Lichtemissionselement (110D) auf dem ersten Substrat entspricht, wobei das defekte Lichtemissionselement eines der Lichtemissionselemente ist.

2. Anzeigevorrichtung nach Anspruch 1, wobei das erste Substrat und das zweite Substrat die gleiche Konfiguration haben.

3. Anzeigevorrichtung nach Anspruch 1 oder 2, wobei
eine erste Interconnect-Verbindung, die auf einer Oberfläche des ersten Substrats gebildet ist, die gleiche Konfiguration wie eine zweite Interconnect-Verbindung hat, die auf einer Oberfläche des zweiten Substrats gebildet ist.

4. Anzeigevorrichtung nach Anspruch 3, die ferner aufweist:
eine Treiberschaltung, die mit der ersten Interconnect-Verbindung und der zweiten Interconnect-Verbindung verbunden ist, wobei
die Treiberschaltung dazu ausgelegt ist, gleichzeitig die Lichtemissionselemente auf dem ersten Substrat und ein Lichtemissionselement auf dem zweiten Substrat zu treiben.

5. Anzeigevorrichtung nach einem der Ansprüche 1 bis 4, wobei
das zweite Substrat eine Mehrzahl von Lichtemissionselementen aufweist, die auf dem zweiten Substrat an Positionen darauf gebildet sind, die nicht mit Positionen der Mehrzahl von Lichtemissionselementen auf dem ersten Substrat überlappen.

6. Anzeigevorrichtung nach einem der Ansprüche 3 bis 5, wobei
die erste Interconnect-Verbindung und die zweite Interconnect-Verbindung jeweils eine Mehrzahl von Datenleitungen und eine Mehrzahl von Abtastleitungen aufweisen,
das erste Substrat die Lichtemissionselemente an Schnittpunkten zwischen der Mehrzahl von Datenleitungen und der Mehrzahl von Abtastleitungen aufweist, und
das zweite Substrat ein Reparaturlichtemissionselement an einem Schnittpunkt aufweist von: einer ausgewählten Datenleitung, die aus der Mehrzahl von Datenleitungen ausgewählt ist; und einer ausgewählten Abtastleitung, die aus der Mehrzahl von Abtastleitungen ausgewählt ist.

7. Anzeigevorrichtung nach einem der Ansprüche 1 bis 6, wobei die Lichtemissionselemente jeweils eine Mikro-Leuchtdiode (LED) sind.

8. Reparaturverfahren zum Reparieren einer defekten Leuchtdiode (LED) in einer Anzeigevorrichtung, die mit einer Mehrzahl von Mikro-LEDs montiert ist, wobei das Reparaturverfahren aufweist:
Stapeln eines zweiten transparenten Substrats (200) auf ein erstes Substrat (100), das die defekte LED (110D) aufweist, und
Montieren einer Reparatur-LED (210R) auf dem zweiten transparenten Substrat an einer Position darauf, die der defekten LED entspricht.

## Revendications

1. Un dispositif d'affichage (10), comprenant :
un premier substrat (100)
comprenant une pluralité d'éléments luminescents (110) disposés de manière bidimensionnelle ;
et
un deuxième substrat (200) empilé sur le premier substrat, où
au moins le deuxième substrat est transparent,
et
le deuxième substrat comprend un élément luminescent de réparation (210R) disposé sur le deuxième substrat à
une position qui correspond à un élément luminescent défectueux (1100) sur le premier substrat,
l'élément luminescent défectueux étant parmi les éléments luminescents.

2. Le dispositif d'affichage selon la revendication 1, où le premier substrat et le deuxième substrat ont une même configuration.

3. Le dispositif d'affichage selon la revendication 1 ou 2, où
un premier moyen d'interconnexion formé sur une surface du premier substrat a une même configuration qu'un deuxième moyen d'interconnexion formé sur une surface du deuxième substrat.

4. Le dispositif d'affichage selon la revendication 3, comprenant en outre :
un circuit de commande connecté au premier moyen d'interconnexion et au deuxième moyen d'interconnexion, où
le circuit de commande est configuré pour
simultanément actionner les éléments luminescents sur le premier substrat et un élément luminescent sur le deuxième substrat.

5. Le dispositif d'affichage selon l'une des revendications 1 à 4, où
le deuxième substrat comprend une pluralité d'éléments luminescents formés sur le deuxième substrat à des positions qui ne se chevauchent pas avec les positions de la pluralité d'éléments luminescents sur le premier substrat.

6. Le dispositif d'affichage selon l'une des revendications 3 à 5, où
le premier moyen d'interconnexion et le deuxième moyen d'interconnexion comprennent chacun une pluralité de lignes de données et une pluralité de lignes de scan,
le premier substrat comprend les éléments luminescents aux intersections entre la pluralité de lignes de données et la pluralité de lignes de scan, et le deuxième substrat comprend un élément luminescent de réparation à l'intersection :
d'une ligne de données sélectionnée parmi la pluralité de lignes de données ; et d'une ligne de scan sélectionnée parmi la pluralité de lignes de scan.

7. Le dispositif d'affichage selon l'une des revendications 1 à 6, où les éléments luminescents sont chacun une micro-diode électroluminescente (LED) .

8. Un procédé de réparation pour réparer une diode électroluminescente (LED) défectueuse dans un dispositif d'affichage monté avec une pluralité de micro LEDs, le procédé de réparation comprenant :
empiler un deuxième substrat transparent (200)
sur un
premier substrat (100) incluant la LED défectueuse (110D), et
monter une LED de réparation (210R)
sur le deuxième substrat transparent à une position qui correspond à la LED défectueuse.
